# EUROPEAN PATENT APPLICATION

(11) **EP 2 660 864 A2**
(43) Date of publication of application: **06.11.2013**
(21) Application number: 12188978.6
(22) Date of filing: 18.10.2012
(51) Int. Cl.: H01L 27/15, H01L 33/60, H01L 33/62

(54) **Light-emitting diode structure and method for manufacturing the same**

(30) Priority: 04.05.2012 TW 101116039
(71) Applicant: Chi Mei Lighting Technology Corp., Tainan City 741 (TW)
(72) Inventor: Chu, Chang-Hsin, 741 Tainan City (TW); Lee, Hsueh-Lin, 741 Tainan City (TW); Hsu, Chih-Kuei, 741 Tainan City (TW); Chen, Yuan-Tze, 741 Tainan City (TW)
(74) Representative: Viering, Jentschura & Partner

(57) **Abstract**

A light-emitting diode (LED) structure and a method for manufacturing the same. The LED structure comprises an insulating substrate, a plurality of LED chips (228) and a plurality of interconnection layers. Each LED chip comprises a first conductivity type semiconductor layer, an active layer and a second conductivity type semiconductor layer stacked in sequence on a surface of the insulating substrate. Each LED chip includes a mesa structure, an exposed portion of the first conductivity type semiconductor layer adjacent to the mesa structure, and a first isolation trench (216,240). The first isolation trench is disposed in the mesa structure. The interconnection layers (226) respectively connect neighboring two of the LED chips.

## Description

### CROSS-REFERENCE TO RELATED APPLICATION

This non-provisional application claims priority under 35 U.S.C. § 119(a) on Patent Application No. 101116039 filed in Taiwan R.O.C. on May 4, 2012, the entire contents of which are hereby incorporated by reference.

Some references, if any, which may include patents, patent applications and various publications, may be cited and discussed in the description of this invention. The citation and/or discussion of such references, if any, is provided merely to clarify the description of the present invention and is not an admission that any such reference is "prior art" to the invention described herein. All references listed, cited and/or discussed in this specification are incorporated herein by reference in their entireties and to the same extent as if each reference was individually incorporated by reference.

### FIELD OF THE INVENTION

The present invention relates to a light-emitting structure, and more particularly to a light-emitting diode (LED) structure and a method for manufacturing the same.

### BACKGROUND OF THE INVENTION

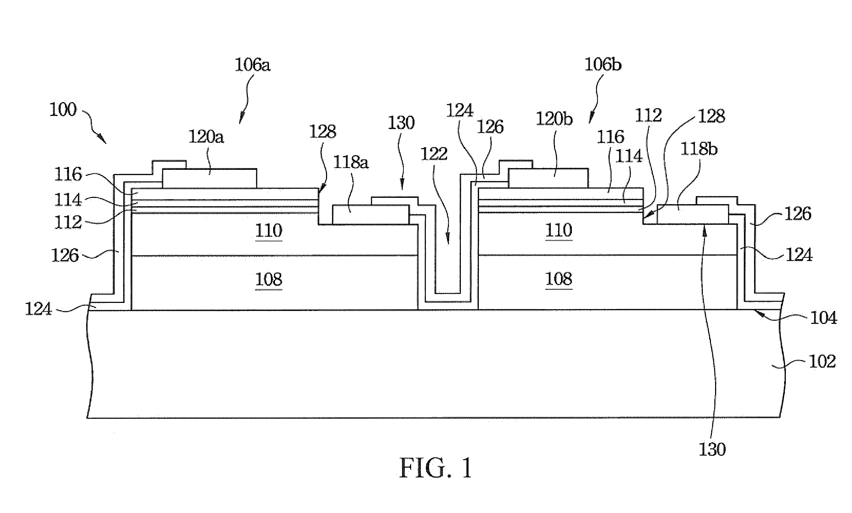

FIG. 1 is a partial sectional view of a conventional series LED structure. The conventional series LED structure 100 includes a plurality of series connected LED chips, for example, LED chips 106a and 106b, disposed on a surface 104 of an insulating substrate 102. The two neighboring LED chips 106a and 106b are separated from each other by an isolation trench 122. Each of the LED chips 106a and 106b includes an undoped semiconductor layer 108, a first conductivity type semiconductor layer 110, an active layer 112, a second conductivity type semiconductor layer 114 and a transparent conductive layer 116 stacked in sequence on a surface of the insulating substrate 102.

Each of the LED chips 106a and 106b has a mesa structure 128 and an exposed portion 130 of the first conductivity type sem iconductor layer 110. A first conductivity type electrode pad 118a and a second conductivity type electrode pad 120a of the LED chip 106a are respectively disposed on the exposed portion 130 of the first conductivity type semiconductor layer 110 and the mesa structure 128. Likewise, a first conductivity type electrode pad 118b and a second conductivity type electrode pad 120b of the LED chip 106b are respectively disposed on the exposed portion 130 of the first conductivity type semiconductor layer 110 and the mesa structure 128.

In the LED structure 100, the insulating layer 124 covers the isolation trench 122, and extends on the first conductivity type semiconductor layer 110 of the LED chip 106a and the transparent conductive layer 116 of the LED chip 106b outside an opening of the isolation trench 122, so as to electrically isolate the two neighboring LED chips 106a and 106b. To connect the two neighboring LED chips 106a and 106b in series, the LED structure 100 has an interconnection layer 126. The interconnection layer 126 extends from the first conductivity type electrode pad 118a of the LED chip 106a, through the exposed portion 130 of the first conductivity type semiconductor layer 110 and the insulating layer 124 inside the isolation trench 122, onto the insulating layer 124 and the second conductivity type electrode pad 120b of the neighboring LED chip 106b, so as to electrically connect the neighboring LED chips 106a and 106b.

Generally speaking, since such a series LED structure 100 is driven by a high voltage, the driving circuit has high efficiency. Secondly, compared with a plurality of independent LED chips, since bonding pads of the series LED structure 100 occupy a small area, the LED structure 100 has a large light-emitting area. In addition, since the current of the series LED structure 100 can be spread over every small LED chip, the current distribution is more uniform than that of a single large-area LED chip, and therefore, the series LED structure 100 achieves better luminous efficiency.

However, since the bottom of the isolation trench 122 of such a conventional series LED structure 100 needs to extend downwards to the surface 104 of the insulating substrate 102, the isolation trench 122 has an excessive aspect ratio (or depth-to width ration), so that the material of the insulating layer 124 is not easily filled in the isolation trench 122, which easily causes discontinuous deposition, resulting in that pores are easily generated in the insulating layer 124. Therefore, during subsequent deposition of the conductive interconnection layer 126, the conductive material of the interconnection layer 126 may be filled in the pores of the insulating layer 124, resulting in short circuit.

In the series LED structure 100, once the LED chip 106a or 106b is short-circuited, the whole series LED structure 100 cannot operate. Therefore, the production yield of the series LED structure 100 is low.

Moreover, the excessive aspect ratio of the isolation trench 122 also easily causes discontinuous deposition of the interconnection layer 126, which will result in disconnection of the interconnection layer 126. In the series LED structure 100, once the LED chip 106a or 106b is disconnected, the whole series LED structure 100 also cannot operate. Therefore, the production yield of the series LED structure 100 is low.

In addition, when it is intended to detect whether a single LED chip is short-circuited, a reverse voltage is applied to the LED chip, and then it is detected through measurement whether a reverse leakage current is produced. However, since the series LED structure 100 is formed by a plurality of LED chips 106a, 106b and the like connected in series, once the LED chip 106a or 106b is short-circuited, or the interconnection layer 126 of the LED chip 106a or 106b is disconnected, no reverse leakage current can be measured in the whole series LED structure 100. Therefore, it cannot be determined through measurement whether the series LED structure 100 has a short circuit defect.

Therefore, a heretofore unaddressed need exists in the art to address the aforementioned deficiencies and inadequacies.

### SUMMARY OF THE INVENTION

Accordingly, in one aspect, the present invention is directed to an LED structure and a method for manufacturing the same, where an interconnection layer extends from an exposed portion of a first conductivity type semiconductor layer of one of neighboring LED chips, directly through a side surface of a mesa structure of the other, onto the mesa structure. Therefore, the aspect ratio of the interconnection layer can be reduced greatly, so that the step coverage capability of the interconnection layer during deposition can be improved effectively, thereby solving the disconnection problem of the interconnection layer.

In another aspect, the present invention is directed to an LED structure and a method for manufacturing the same, where a mesa structure of an LED chip may have a trapezoidal inclined side surface, so that the step coverage capability of the interconnection layer can be further improved, thereby avoiding the disconnection phenomenon during deposition of the interconnection layer more effectively.

In still another aspect, the present invention is directed to an LED structure and a method for manufacturing the same, where a light-emitting region of an LED chip is separated from a first conductivity type semiconductor layer of a neighboring LED chip by an isolation trench, and the isolation trench is filled with an insulating layer only and is not filled with any conductive material. Furthermore, a current blocking layer may further be disposed on an opening of the isolation trench to achieve electrical isolation. Therefore, even if the deposition of the insulating layer inside the isolation trench is discontinuous, no short circuit problem will occur in the light-emitting region as no conductive material is filled in the isolation trench.

In a further aspect, the present invention is directed to an LED structure and a method for manufacturing the same, which can effectively solve the short circuit and disconnection problems, so that the production yield of the series LED structure can be improved greatly, thereby reducing the manufacturing cost.

In a further aspect, the present invention is directed to an LED structure and a method for manufacturing the same, which can effectively solve the short circuit and disconnection problems, so that the reverse leakage current detection means is not required.

In a further aspect, the present invention is directed to an LED structure and a method for manufacturing the same, where a short circuit defect in the LED structure can be determined successfully by forward/reverse current detection.

To achieve the objectives of the present invention, an LED structure is provided. The LED structure includes an insulating substrate, a plurality of LED chips and a plurality of interconnection layers. Each of the LED chips includes a first conductivity type semiconductor layer, an active layer and a second conductivity type semiconductor layer stacked in sequence on a surface of the insulating substrate. Each of the LED chips includes a mesa structure, an exposed portion of the first conductivity type semiconductor layer adjacent to the mesa structure, and a first isolation trench. The first isolation trench is disposed in the mesa structure. The interconnection layers respectively connect neighboring two of the LED chips.

According to an embodiment of the present invention, in each of the LED chips, a bottom of the first isolation trench exposes the surface of the insulating substrate.

According to another embodiment of the present invention, each of the LED chips further includes an undoped semiconductor layer between the surface of the insulating substrate and the first conductivity type semiconductor layer.

According to still another embodiment of the present invention, each of the LED chips further includes an insulating layer, and the insulating layer is filled in the first isolation trench to close an opening of the first isolation trench.

According to yet another embodiment of the present invention, each of the LED chips further includes a current blocking layer between the interconnection layer on the mesa structure and the insulating layer.

According to yet another embodiment of the present invention, each of the LED chips further includes a transparent conductive layer between the interconnection layer on the mesa structure and the current blocking layer, and extending on the second conductivity type semiconductor layer of the mesa structure.

According to yet another embodiment of the present invention, each of the LED chips further includes a transparent conductive layer disposed adjacent to the current blocking layer, and the interconnection layer extends on and covers a part of the transparent conductive layer.

According to yet another embodiment of the present invention, each of the interconnection layers extends from the exposed portion of the first conductivity type semiconductor layer of one of the neighboring LED chips to the mesa structure of the other one of the neighboring LED chips.

According to yet another embodiment of the present invention, each of the LED chips further includes a current blocking layer, and the current blocking layer covers a side surface of the mesa structure where the interconnection layer is located.

To achieve the objectives of the present invention, a method for manufacturing an LED structure is further provided, which includes the following steps. An insulating substrate is provided. An epitaxial structure is formed. The epitaxial structure includes a first conductivity type semiconductor layer, an active layer and a second conductivity type semiconductor layer stacked in sequence on a surface of the insulating substrate. A plurality of first isolation trenches and a plurality of second isolation trenches are formed in the epitaxial structure to define a plurality of LED chips. The first isolation trenches are respectively adjacent to the second isolation trenches. A part of the second conductivity type semiconductor layer and a part of the active layer are removed to define a mesa structure and an exposed portion of the first conductivity type semiconductor layer of each of the LED chips. Each of the LED chips includes one of the first isolation trenches, and the one of the first isolation trenches is disposed in the mesa structure. A plurality of interconnection layers is formed to respectively connect neighboring two of the LED chips.

According to an embodiment of the present invention, before the step of removing the part of the second conductivity type semiconductor layer and the part of the active layer, the method for manufacturing an LED structure further includes forming a plurality of first insulating layers and a plurality of second insulating layers, and respectively filling the first insulating layers and the second insulating layers in the first isolation trenches and the second isolation trenches.

According to another embodiment of the present invention, the step of forming the first insulating layers and the second insulating layers further includes the following steps. An insulating material covering the epitaxial structure is formed, and filled in the first isolation trenches and the second isolation trenches. An etch back step is performed to remove a part of the insulating material.

According to still another embodiment of the present invention, after the step of forming the first insulating layers and the second insulating layers, the method for manufacturing an LED structure further includes the following steps. A plurality of first current blocking layers respectively located on the mesa structures is formed, where each of the first current blocking layers is located between the interconnection layer on the mesa structure and the first insulating layer. A plurality of second current blocking layers respectively located on the second insulating layers is formed. A plurality of transparent conductive layers respectively located on the mesa structures is formed, where each of the transparent conductive layers is located between the interconnection layer on the mesa structure and the first current blocking layer, and extends on the second conductivity type semiconductor layer of the mesa structure.

According to yet another embodiment of the present invention, each of the interconnection layers is directly connected from the exposed portion of the first conductivity type semiconductor layer of one of the neighboring LED chips to a side surface of the mesa structure of the other one ofthe neighboring LED chips, and extends on the mesa structure.

To achieve the objectives of the present invention, an LED structure is further provided. The LED structure includes an insulating substrate, a plurality of LED chips and at least one electrode pad row. The LED chips are disposed on the insulating substrate, and arranged in an array, where the array includes a plurality of rows and a plurality of columns, and the LED chips are connected to one another in series or in parallel. The at least one electrode pad row is disposed adjacent to a first row of the array, and respectively electrically connected to the LED chips of the first row.

According to an embodiment of the present invention, the at least one electrode pad row is formed by arranging a plurality of first conductivity type electrode pads and a plurality of second conductivity type electrode pads in a staggered manner, the first conductivity type electrode pads and the second conductivity type electrode pads are respectively electrically connected to the LED chips of the first row, and the LED chips are connected in series with the electrode pad row.

According to another embodiment of the present invention, the at least one electrode pad row includes a first electrode pad row and a second electrode pad row, the first electrode pad row and the second electrode pad row are respectively disposed adjacent to the first row and a last row of the array, the first electrode pad row is respectively electrically connected to the LED chips of the first row, and the second electrode pad row is respectively electrically connected to the LED chips of the last row.

According to still another embodiment of the present invention, each of the first electrode pad row and the second electrode pad row is formed by arranging a plurality of first conductivity type electrode pads and a plurality of second conductivity type electrode pads in a staggered manner, and the LED chips, the first electrode pad row and the second electrode pad row are connected in series.

According to yet another embodiment of the present invention, the first electrode pad row includes a plurality of first conductivity type electrode pads electrically connected to one another, the second electrode pad row includes a plurality of second conductivity type electrode pads electrically connected to one another, and the LED chips are connected in parallel with the first electrode pad row and the second electrode pad row.

According to yet another embodiment of the present invention, the first electrode pad row includes a first conductivity type electrode pad extending beside a first row of the array, the second electrode pad row includes a second conductivity type electrode pad extending beside a last row of the array, and the LED chips are connected in parallel with the first electrode pad row and the second electrode pad row.

These and other aspects of the present invention will become apparent from the following description of the preferred embodiment taken in conjunction with the following drawings, although variations and modifications therein may be effected without departing from the spirit and scope of the novel concepts of the disclosure.

### BRIEF DESCRIPTION OF THE DRAWINGS

The accompanying drawings illustrate one or more embodiments of the invention and together with the written description, serve to explain the principles of the invention. Wherever possible, the same reference numbers are used throughout the drawings to refer to the same or like elements of an embodiment, and wherein:
FIG. 1 is a partial sectional view of a conventional series LED structure;
FIG. 2 is a schematic top view of an LED structure according to an embodiment of the present invention;
FIG. 3 is a sectional view of an LED structure taken along Line AA' of FIG. 2;
FIG. 3A is a sectional view of another LED structure taken along Line AA' of FIG. 2;
FIG. 4 is a sectional view of an LED structure taken along Line BB' of FIG. 2;
FIG. 5A to FIG. 5G are sectional views illustrating processes of an LED structure according to an embodiment of the present invention;
FIG. 6A is a schematic top view of an LED structure according to another embodiment of the present invention;
FIG. 6B is a schematic top view of an LED structure according to still another embodiment of the present invention;
FIG. 7A is a schematic top view of an LED structure according to yet another embodiment of the present invention;
FIG. 7B is a schematic top view of an LED structure according to yet another embodiment of the present invention;
FIG. 8 is a schematic top view of an LED structure according to yet another embodiment of the present invention; and
FIG. 9 is a schematic top view of an LED structure according to yet another embodiment of the present invention.

### DETAILED DESCRIPTION OF THE INVENTION

The present invention is more particularly described in the following examples that are intended as illustrative only since numerous modifications and variations therein will be apparent to those skilled in the art. Various embodiments of the invention are now described in detail. Referring to the drawings, like numbers indicate like components throughout the views. As used in the description herein and throughout the claims that follow, the meaning of "a", "an", and "the" includes plural reference unless the context clearly dictates otherwise. Also, as used in the description herein and throughout the claims that follow, the meaning of "in" includes "in" and "on" unless the context clearly dictates otherwise. Moreover, titles or subtitles may be used in the specification for the convenience of a reader, which shall have no influence on the scope of the present invention.

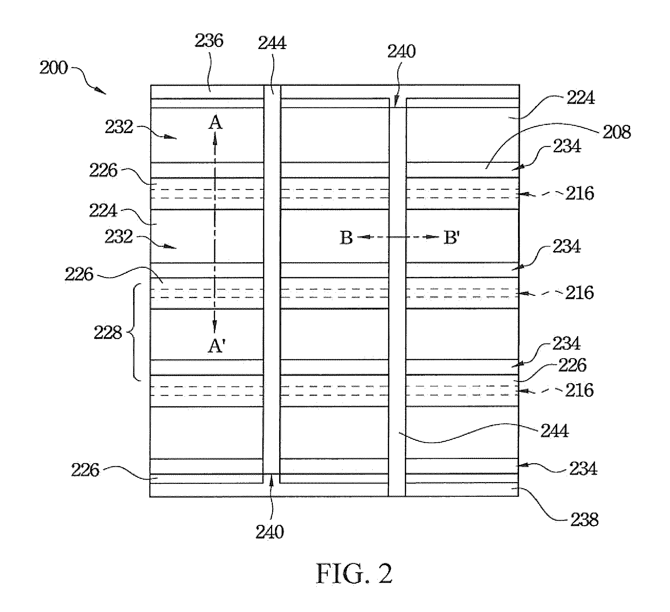

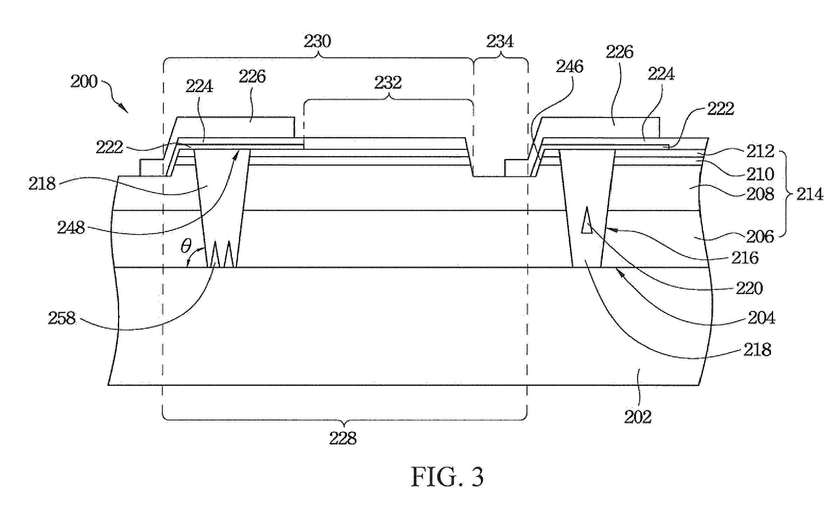

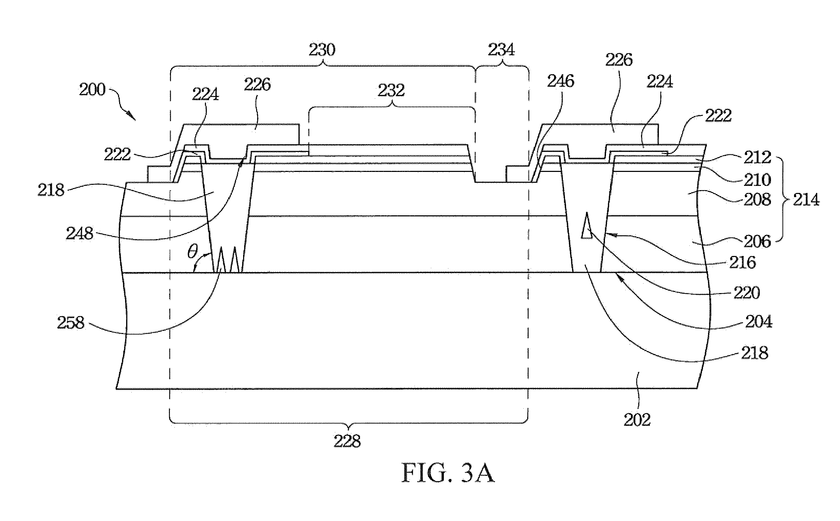

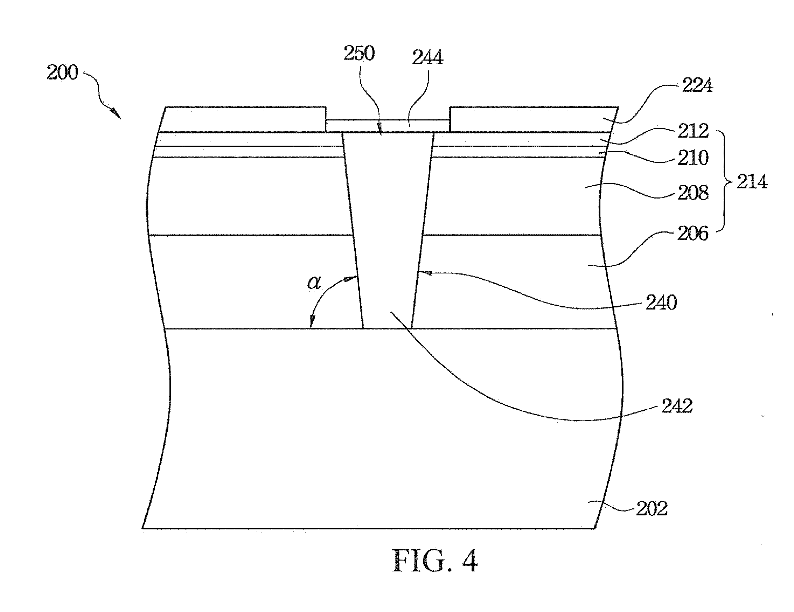

Referring to FIGS. 2-4, FIG. 2 is a top view of an LED structure according to an embodiment of the present invention, FIG. 3 is a sectional view of an LED structure taken along Line AA' of FIG. 2, and FIG. 4 is a sectional view of an LED structure taken along Line BB' of FIG. 2. In this embodiment, the LED structure 200 may be a High Voltage LED (HV LED).

Referring now to FIG. 2, the LED structure 200 is formed by a plurality of LED chips 228 connected in series. In the embodiment shown in FIG. 2, the LED structure 200 is formed by 12 LED chips 228 connected in series. Isolation trenches 216 and 240 are disposed around each of the LED chips 228 to electrically isolate the LED chips 228. Moreover, the neighboring LED chips 228 are electrically connected through a conductive interconnection layer 226, so as to connect all the LED chips 228 in series.

In an embodiment, referring to FIGS. 2 and 3, the LED structure 200 mainly includes an insulating substrate 202, a plurality of LED chips 228, and a plurality of interconnection layers 226. The material of the insulating substrate 202 may be for example sapphire. In some examples, the insulating substrate 202 may be a patterned sapphire substrate (PSS). A plurality of pattern structures 258 is formed on a surface 204 of the insulating substrate 202. Through the disposition of the pattern structures 258, the light extraction efficiency of the LED chips 228 can be improved.

The LED chips 228 are disposed on the surface 204 of the insulating substrate 202. Each of the LED chips 228 includes an epitaxial structure 214. In this embodiment, the epitaxial structure 214 includes an undoped semiconductor layer 206, a first conductivity type semiconductor layer 208, an active layer 210 and a second conductivity type semiconductor layer 212 grown and stacked in sequence on the surface 204 of the insulating substrate 202. In the embodiment of the present invention, the first conductivity type and the second conductivity type are different conductivity types. For example, one of the first conductivity type and the second conductivity type is n-type, and the other type is p-type. In another embodiment, the epitaxial structure 214 may not include the undoped semiconductor layer 206.

The active layer 210 may be for example a multiple quantum well (MQW) structure formed by multiple sets of alternately stacked quantum wells and barrier layers. In an example, the material of the undoped semiconductor layer 206, the first conductivity type semiconductor layer 208, the active layer 210 and the second conductivity type semiconductor layer 212 may be for example a GaN-series material.

Each of the LED chips 228 includes a mesa structure 230 and an exposed portion 234 adjacent to the mesa structure 230. The mesa structure 230 includes a part of the undoped semiconductor layer 206, a part of the first conductivity type semiconductor layer 208, a part of the active layer 210 and a part of the second conductivity type semiconductor layer 212. On the other hand, the exposed portion 234 is a part exposed out of the first conductivity type semiconductor layer 208 after removing a part of the second conductivity type semiconductor layer 212 and a part of the active layer 210 or even a part of the first conductivity type semiconductor layer 208 when the mesa structure 230 is defined in the epitaxial structure 214. Therefore, the exposed portion 234 is an exposed portion of the first conductivity type semiconductor layer 208, and the exposed portion 234 includes a part of the undoped semiconductor layer 206 and a part of the first conductivity type semiconductor layer 208, but does not include the active layer 210 and the second conductivity type semiconductor layer 212.

In an embodiment, referring to FIG. 3, the mesa structure 230 may for example have a trapezoidal section, and at this time, the mesa structure 230 has an inclined side surface 246. The inclined side surface 246 of the mesa structure 230 may facilitate subsequent deposition of the interconnection layer 226. However, in another embodiment, the mesa structure 230 may have a rectangular section, and at this time, the mesa structure 230 has a vertical side surface 246.

Each of the LED chips 228 further includes an isolation trench 216. The isolation trench 216 is disposed in the mesa structure 230, and preferably adjacent to the exposed portion 234 of the neighboring LED chip 228. In the mesa structure 230, the isolation trench 216 extends from the second conductivity type semiconductor layer 212 towards the undoped semiconductor layer 206. Therefore, a bottom of the isolation trench 216 is located in the undoped semiconductor layer 206. In the embodiment shown in FIG. 3, the bottom of the isolation trench 216 directly extends to the surface 204 of the insulating substrate 202 to expose the surface 204 of the insulating substrate 202. In an embodiment where the epitaxial structure 214 does not include the undoped semiconductor layer 206, the isolation trench 216 extends from the second conductivity type semiconductor layer 212 towards the surface 204 of the insulating substrate 202. Therefore, at this time, the bottom of the isolation trench 216 exposes a part of the surface 204 of the insulating substrate 202. As shown in FIG. 3, the isolation trench 216 exposes the pattern structures 258 on the surface 204 of the insulating substrate 202.

In some embodiments, each of the LED chips 228 may further include an insulating layer 218. The insulating layer 218 is filled in the isolation trench 216, covers the pattern structures 258 of the insulating substrate 202, and preferably closes an opening 248 of the isolation trench 216. The insulating layer 218 may fill up the isolation trench 216, as the isolation trench 216 shown in the left part of FIG. 3. However, in another embodiment, the insulating layer 218 may not fill up the isolation trench 216, and pores 220 are formed in the isolation trench 216, as the isolation trench 216 shown in the right part of FIG. 3. In still some embodiments, as shown in FIG. 3A, the insulating layer 218 may fill only a part of the depth of the isolation trench 216.

In an embodiment, as shown in FIG. 3, the isolation trench 216 has an inverted trapezoidal section, so as to facilitate the deposition of the insulating layer 218 into the isolation trench 216. In an example, an angle θ between the isolation trench 216 and the surface 204 of the insulating substrate 202 may be for example from 30° to 90°. However, in another embodiment, the isolation trench 216 may have a rectangular section. The material of the insulating layer 218 may be for example SiO₂ or SiNₓ.

In an embodiment, each of the LED chips 228 may also selectively include a current blocking layer 222. As shown in FIG. 3, the current blocking layer 222 is disposed on the mesa structure 230, and located above the isolation trench 216, and covers the insulating layer 218, a part of the second conductivity type semiconductor layer 212, and the side surface 246 of the mesa structure 230 where the interconnection layer 226 is located. When the insulating substrate 202 is a PSS and the insulating layer 218 does not fill up the isolation trench 216, the thickness of the insulating layer 218 is at least equal to that of the current blocking layer 222. In a preferred embodiment, the thickness of the insulating layer 218 is preferably equal to the height of the pattern structures 258, so as to reduce the structural relief caused by the pattern structures 258, thereby avoiding the disconnection phenomenon of the interconnection layer 226.

Referring to FIG. 3A again, when the insulating layer 218 does not fill up the isolation trench 216, the current blocking layer 222 covers a part of the second conductivity type semiconductor layer 212 on the mesa structure 230, side surfaces of the isolation trench 216 and the insulating layer in the isolation trench 216, and the side surface 246 of the mesa structure 230 where the interconnection layer 226 is located.

Each of the LED chips 228 may further selectively include a transparent conductive layer 224. The material of the transparent conductive layer 224 may be for example ITO. The transparent conductive layer 224 is disposed on the mesa structure 230, covers the current blocking layer 222, and extends on the second conductivity type semiconductor layer 212 of the mesa structure 230. In another embodiment, the transparent conductive layer 224 may be only located on the second conductivity type semiconductor layer 212 of the mesa structure 230, but does not cover the current blocking layer 222. While in this embodiment, the interconnection layer 226 extends on and covers a part of the transparent conductive layer 224, so as to achieve electrical conduction.

In the LED structure 200, the interconnection layers 226 respectively connect the neighboring LED chips 228, so as to electrically connect the LED chips 228 in series. The interconnection layer 226 extends from the exposed portion 234 of the first conductivity type semiconductor layer 208 of one LED chip 228 in two neighboring LED chips 228 to the transparent conductive layer 224 on the mesa structure 230 of the other LED chip 228. As shown in FIG. 3, the interconnection layer 226 directly extends from the exposed portion 234 of one LED chip 228 in the two neighboring LED chips 228 to the current blocking layer 222 on the side surface 246 of the mesa structure 230 of the other LED chip 228, and is then connected to the transparent conductive layer 224 above the mesa structure 230 along the side surface 246 of the mesa structure 230. Therefore, the lowest surface of the interconnection layer 226 is located on the exposed portion 234 of the first conductivity type semiconductor layer 208, and contacts a surface of the exposed portion 234.

A part of the interconnection layer 226 on the mesa structure 230 covers the current blocking layer 222 and the transparent conductive layer 224 that are above the isolation trench 216. Therefore, as shown in FIG. 3, the current blocking layer 222 is located between the interconnection layer 226 above the mesa structure 230 and the insulating layer 218 inside the isolation trench 216, and the transparent conductive layer 224 is located between the interconnection layer 226 above the mesa structure 230 and the current blocking layer 222. In an embodiment, the current blocking layer 222 may partially extend laterally to the outside of the interconnection layer 226, so as to achieve better current blocking effect, and prevent a large current from being directly poured downwards from the interconnection layer 226 into the LED chips 228 to cause current crowding, thereby forcing the current to flow into a light-emitting region 232 of the mesa structure 230 through the transparent conductive layer 224. Thus, the luminous efficiency of the LED chips 228 can be improved greatly. Therefore, in a preferred embodiment, the transparent conductive layer 224 may extend on the second conductivity type semiconductor layer 212 on the light-emitting region 232 in the mesa structure 230.

The material of the interconnection layer 226 is a conductive material, which may be for example metal. In an embodiment, the interconnection layer 226 may be a Cr/Pt/Au stack structure formed by a Cr layer, a Pt layer and an Au layer stacked in sequence.

Referring to FIGS. 2 and 4, each of the LED chips 228 further includes another isolation trench 240. The isolation trench 240 is disposed in the epitaxial structure 214 outside the mesa structure 230, and adjacent to the isolation trench 216. As shown in FIG. 2, the isolation trench 240 may electrically isolate the LED chips 228 of two neighboring columns. Therefore, different from the isolation trench 216, no conductive material such as the transparent conductive layer or the interconnection layer covers the isolation trench 240.

The isolation trench 240 extends from the second conductivity type semiconductor layer 212 of the epitaxial structure 214 to the undoped semiconductor layer 206. Therefore, a bottom of the isolation trench 240 is located in the undoped semiconductor layer 206. In the embodiment shown in FIG. 4, the bottom of the isolation trench 240 directly extends to the surface 204 of the insulating substrate 202 to expose the surface 204 of the insulating substrate 202. In an embodiment where the epitaxial structure 214 does not include the undoped semiconductor layer 206, the isolation trench 240 extends from the second conductivity type semiconductor layer 212 towards the surface 204 of the insulating substrate 202. Therefore, at this time, the bottom of the isolation trench 240 exposes a part of the surface 204 of the insulating substrate 202.

In some embodiments, each of the LED chips 228 may further include another insulating layer 242. The insulating layer 242 is filled in the isolation trench 240, and preferably closes an opening 250 of the isolation trench 240. The insulating layer 242 may fill up the isolation trench 240. However, in another embodiment, the insulating layer 242 may not fill up the isolation trench 240. In an embodiment, as shown in FIG. 4, the isolation trench 240 has an inverted trapezoidal section, so as to facilitate the deposition of the insulating layer 242 into the isolation trench 240. In an example, an angle α between the isolation trench 240 and the surface 204 of the insulating substrate 202 may be for example from 30° to 90°. However, in another embodiment, the isolation trench 240 may have a rectangular section. The material of the insulating layer 242 may be for example SiO₂ or SiNₓ.

In an embodiment, each of the LED chips 228 may also selectively include a current blocking layer 244. As shown in FIG. 4, the current blocking layer 244 is located above the isolation trench 240, and covers the insulating layer 242 in the isolation trench 240, and the second conductivity type semiconductor layer 212 at a periphery of the opening 250 of the isolation trench 240.

Referring to FIG. 2 again, a front end and a rear end of the LED structure 200 may be respectively provided with second conductivity type electrode pads 236 and first conductivity type electrode pads 238. The material of the first conductivity type electrode pads 238 and the second conductivity type electrode pads 236 is a conductive material, for example, metal. In an embodiment, the first conductivity type electrode pads 238 and the second conductivity type electrode pads 236 may each be a Cr/Pt/Au stack structure formed by a Cr layer, a Pt layer and an Au layer stacked in sequence.

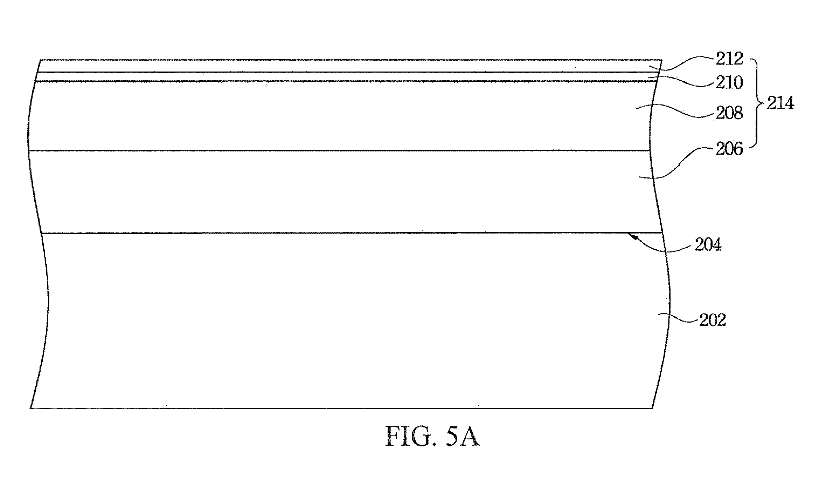

FIGS. 5A-5G are sectional views illustrating processes of an LED structure according to an embodiment of the present invention. In this embodiment, in order to fabricate an LED structure 200, firstly, an insulating substrate 202, for example, a sapphire substrate, is provided. In an embodiment, the insulating substrate 202 may be a PSS having a plurality of pattern structures disposed on a surface 204 thereof, where the pattern structures may be laid over the whole surface 204. Then, an undoped semiconductor layer 206, a first conductivity type semiconductor layer 208, an active layer 210 and a second conductivity type semiconductor layer 212 are formed in sequence on the surface 204 of the insulating substrate 202 by epitaxial growth, for example, Metal Organic Chemical Vapor Deposition (MOCVD). As shown in FIG. 5A, the undoped semiconductor layer 206, the first conductivity type semiconductor layer 208, the active layer 210 and the second conductivity type semiconductor layer 212 are stacked in sequence to form an epitaxial structure 214. In another embodiment, the epitaxial structure 214 may not include the undoped semiconductor layer 206.

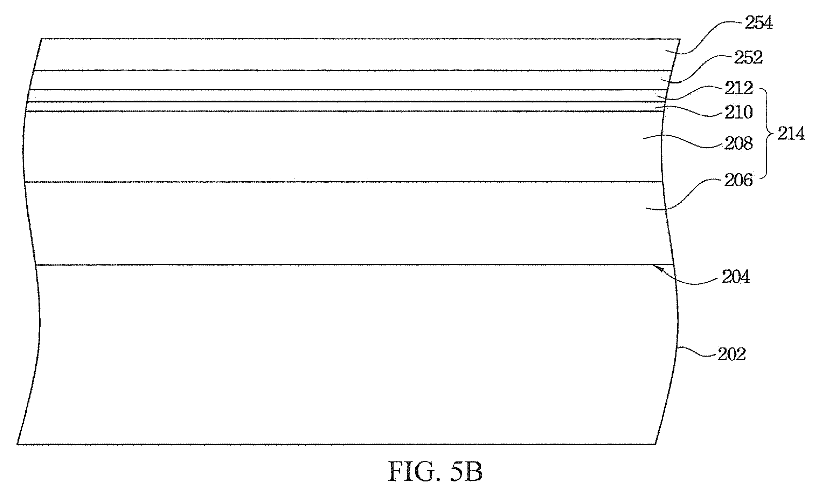

Next, an etching stop layer 252 covering the second conductivity type semiconductor layer 212 is formed by for example deposition. The material of the etching stop layer 252 may be for example SiNₓ. As shown in FIG. 5B, a hard mask layer 254 covering the etching stop layer 252 is then formed by for example deposition. The material of the hard mask layer 254 may be for example Ni or SiO₂. The etching stop layer 252 may be used as an etching end when defining the pattern of the hard mask layer 254.

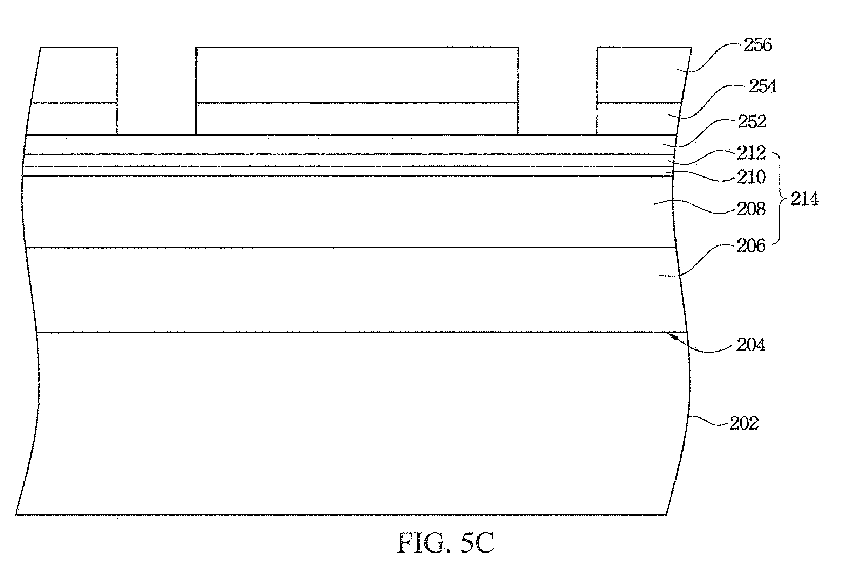

Then, a photoresist layer 256 covering the hard mask layer 254 is first formed by for example coating. Subsequently, the pattern of the photoresist layer 256 is defined by for example a lithography process through removing a part of the photoresist layer 256 to expose a part of the hard mask layer 254, so as to define a predetermined position and shape of an isolation trench 216 in the photoresist layer 256. Afterwards, the exposed portion of the hard mask layer 254 is removed by for example etching with the patterned photoresist layer 256 as an etching mask and the etching stop layer 252 as an etching end, so as to transfer the pattern in the photoresist layer 256 into the hard mask layer 254. As such, the predetermined position and shape of the isolation trench 216 previously defined in the photoresist layer 256 can be transferred to the hard mask layer 254, as shown in FIG. 5C.

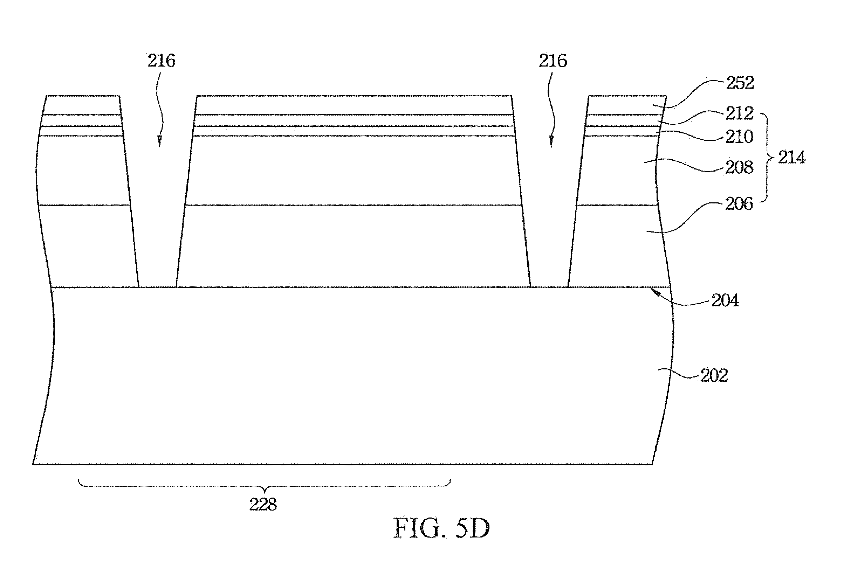

Then, the epitaxial structure 214 is etched by for example inductively coupled plasma (ICP) etching with the patterned photoresist layer 256 and the hard mask layer 254 as an etching mask, to remove a part of the second conductivity type semiconductor layer 212, a part of the active layer 210, a part of the first conductivity type semiconductor layer 208 and a part of the undoped semiconductor layer 206, so as to transfer the pattern in the hard mask layer 254 into the epitaxial structure 214, and form isolation trenches 216 and 240 in the epitaxial structure 214. The isolation trenches 216 are respectively adjacent to the isolation trenches 240, and the isolation trenches 216 and 240 define a plurality of LED chips 228 in the epitaxial structure 214, as shown in FIG. 5D. Each of the LED chips 228 includes one of the isolation trenches 216 and one of the isolation trenches 240.

In an embodiment, as shown in FIG. 4 and FIG. 5D, a bottom of each of the isolation trenches 216 and 240 exposes a part of the surface 204 of the insulating substrate 202. In another embodiment, the bottoms of the isolation trenches 216 and 240 may be located in the undoped semiconductor layer 206. In an embodiment where the epitaxial structure 214 does not include the undoped semiconductor layer 206, the isolation trenches 216 and 240 extend from the second conductivity type semiconductor layer 212 towards the surface 204 of the insulating substrate 202, and each of the isolation trenches 216 and 240 exposes a part of the surface 204 of the insulating substrate 202.

After the isolation trenches 216 and 240 are formed, the photoresist layer 256 and the hard mask layer 254 that are left are removed, to expose the etching stop layer 252, so as to form a structure as shown in FIG. 5D. In another embodiment, the etching stop layer 252 covering the second conductivity type semiconductor layer 212 may be formed after the photoresist layer 256 and the hard mask layer 254 are removed.

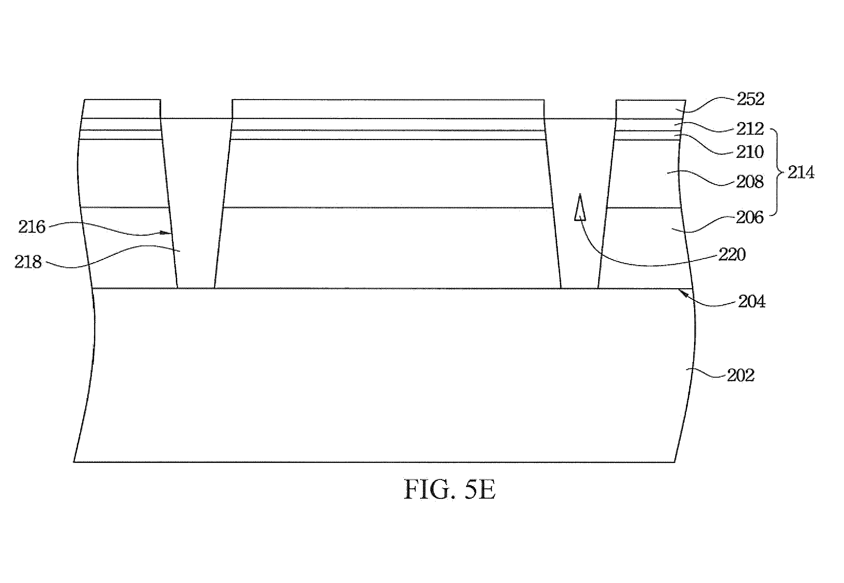

Next, according to the product requirements, an insulating material covering the etching stop layer 252 and the isolation trenches 216 and 240 may be selectively formed by for example Plasma Enhanced Chemical Vapor Deposition (PECVD). The insulating material may be for example SiO₂ or SiNₓ. Then, in an embodiment, the insulating material on the etching stop layer 252 may be removed by for example etch back with the etching stop layer 252 as an etching end, so as to respectively fill insulating layers 218 and 242 into the isolation trenches 216 and 240, as shown in FIG. 5E and FIG. 4. In some embodiments, an excessive part of the insulating material on the etching stop layer 252 may be removed by for example Chemical Mechanical Polishing (CMP). At this time, the etching stop layer 252 is used as a polishing end.

The insulating layers 218 and 242 preferably respectively close an opening 248 of the isolation trench 216 and an opening 250 of the isolation trench 240. Moreover, the insulating material may fill up the isolation trenches 216 and 240. In another embodiment, the insulating material may not fill up the isolation trenches 216 and 240, and pores 220 are formed in the isolation trenches 216 and 240, as the isolation trench 216 in the right part of the structure shown in FIG. 5E. In still another embodiment, the insulating material may fill only a part of the depth of the isolation trenches 216 and 240.

After the insulating layers 218 and 242 are formed, the etching stop layer 252 is removed to expose the second conductivity type semiconductor layer 212. In an embodiment, mesa definition of the LED chips 228 may be directly performed. However, in another embodiment, first, a current blocking material covering the insulating layers 218 and 242 and the second conductivity type semiconductor layer 212 may be selectively formed by for example deposition. Subsequently, a part of the current blocking material on the second conductivity type semiconductor layer 212 is removed by for example lithography and etching, so as to form current blocking layers 222 and 244, as shown in FICi. 5F and FIG. 4. The current blocking layer 222 covers the insulating layer 218, and extends on the second conductivity type semiconductor layer 212 outside the opening 248 of the isolation trench 216. Likewise, the current blocking layer 244 covers the insulating layer 242, and extends on the second conductivity type semiconductor layer 212 outside the opening 250 of the isolation trench 240.

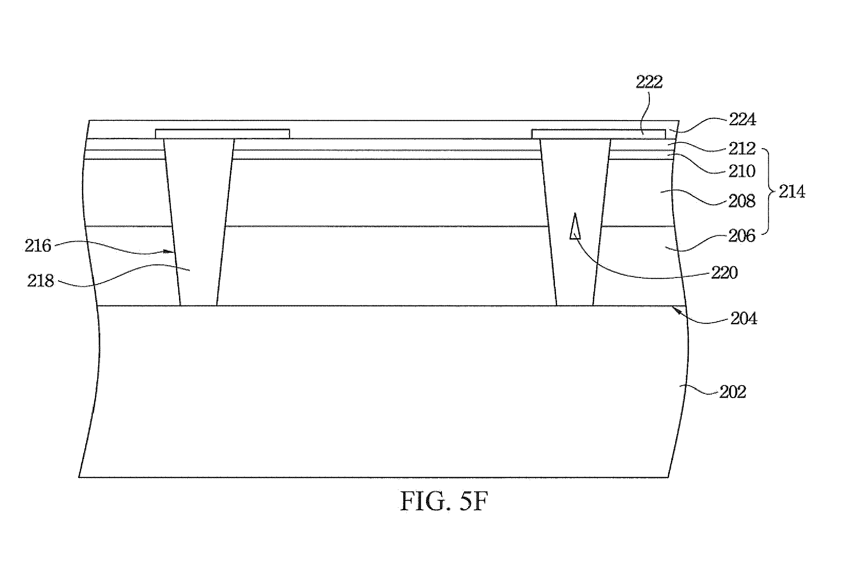

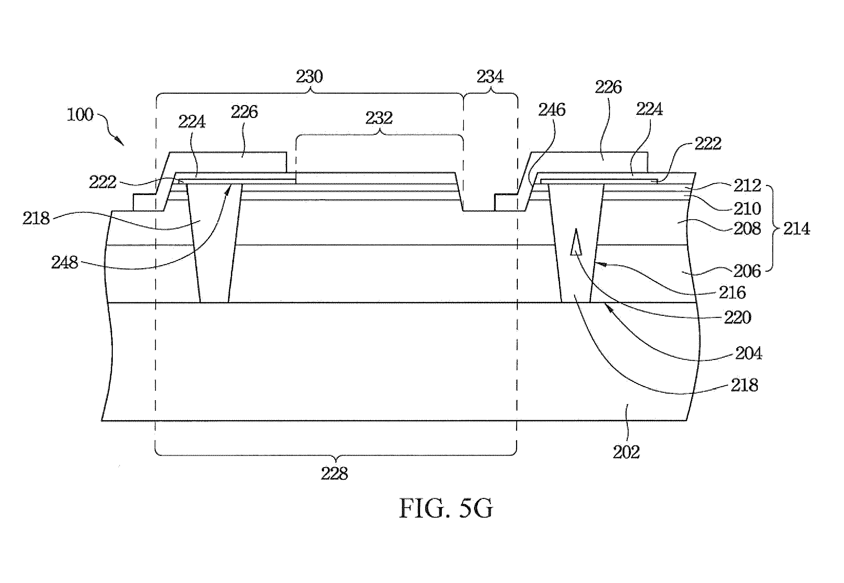

Referring to FIG. 5F, in an embodiment where the current blocking layers 222 and 244 are disposed, a transparent conductive layer 224 covering the current blocking layers 222 and 244 and the second conductivity type semiconductor layer 212 may then be formed by for example evaporation or sputtering. The material of the transparent conductive layer 224 may be for example ITO. Next, the mesa definition of each of the LED chips 228 may be performed by for example a lithography and etching process such as an ICP etching process. As shown in FIG. 5G, in the mesa definition process, a part of the transparent conductive layer 224, a part of the second conductivity type semiconductor layer 212, and a part of the active layer 210 are removed, or even a part of the first conductivity type semiconductor layer 208 is removed, to expose a part of the first conductivity type semiconductor layer 208, so as to form a mesa structure 230 and an exposed portion 234 of each of the LED chips 228. Moreover, as shown in FIG. 4, in the mesa definition process, the transparent conductive layer 224 on the isolation trench 240 is further removed. After the mesa definition, the isolation trench 216 of each of the LED chips 228 is located in the mesa structure 230, and the transparent conductive layer 224 is located on the mesa structure 230.

In another embodiment, after the mesa definition of each of the LED chips 228 is completed, the current blocking layers 222 and 244 are formed, and then the transparent conductive layer 224 is formed. At this time, as shown in FIG. 3, the current blocking layer 222 is located on the mesa structure 230, and located above the isolation trench 216, and covers the insulating layer 218, a part of the second conductivity type semiconductor layer 212, and a side surface 246 of the mesa structure 230 where the subsequently formed interconnection layer 226 is located. In addition, the transparent conductive layer 224 is located on the mesa structure 230, covers the current blocking layer 222, and extends on the second conductivity type semiconductor layer 212 of the mesa structure 230. On the other hand, the current blocking layer 244 is located above the isolation trench 240, and covers the insulating layer 242 in the isolation trench 240, and the second conductivity type semiconductor layer 212 at a periphery of the opening 250 of the isolation trench 240.

Then, a conductive layer covering the mesa structure 230 and the exposed portion 234 of the first conductivity type semiconductor layer 208 is formed by for example deposition. Subsequently, a part of the metal layer is removed by for example lithography and etching to form a plurality of interconnection layers 226, a plurality of first conductivity type electrode pads 238 and a plurality of second conductivity type electrode pads 236, so as to obtain a series LED structure 200, as shown in FIG. 5G. The material of the interconnection layer 226, the first conductivity type electrode pads 238 and the second conductivity type electrode pads 236 may be for example metal. In an embodiment, the interconnection layers 226, the first conductivity type electrode pads 238 and the second conductivity type electrode pads 236 may each be a Cr/Pt/Au stack structure formed by a Cr layer, a Pt layer and an Au layer stacked in sequence.

Referring to FIG. 2 again, the first conductivity type electrode pads 238 and the second conductivity type electrode pads 236 are respectively disposed on a front end and a rear end of the LED structure 200. Moreover, the interconnection layers 226 respectively connect the neighboring LED chips 228, so as to electrically connect the LED chips 228 in series. As shown in FIG. 5G, the interconnection layer 226 directly extends from the exposed portion 234 of one LED chip 228 in two neighboring LED chips 228 to the side surface 246 of the mesa structure 230 of the other LED chip 228, and then extends upwards along the side surface 246 of the mesa structure 230 to be connected to the transparent conductive layer 224 above the mesa structure 230. Therefore, the current blocking layer 222 is located between the interconnection layer 226 above the mesa structure 230 and the insulating layer 218 in the isolation trench 216, and the transparent conductive layer 224 is located between the interconnection layer 226 above the mesa structure 230 and the current blocking layer 222.

In the series LED structure 200 of this embodiment, the interconnection layer 226 is connected from the exposed portion 234 of the first conductivity type semiconductor layer 208 of one of two neighboring LED chips 228, directly through the side surface 246 of the mesa structure 230 of the other LED chip 228, to the transparent conductive layer 224 on the mesa structure 230. Therefore, the aspect ratio of the interconnection layer 226 can be reduced greatly, so that the step coverage capability of the interconnection layer 226 during deposition can be improved effectively, thereby solving the disconnection problem of the interconnection layer 226. Secondly, since the mesa structure 230 of the LED chip 228 may have a trapezoidal inclined side surface 246, the step coverage capability of the interconnection layer 226 can be further improved, thereby avoiding the disconnection phenomenon during deposition of the interconnection layer 226 more effectively.

Furthermore, the light-emitting region 232 of the LED chip 228 is separated from the first conductivity type semiconductor layer 208 of the neighboring LED chip 228 by the isolation trench 216, and the isolation trench 216 is filled with the insulating layer 218 only and is not filled with any conductive material. Moreover, the current blocking layer 222 may further be disposed on the opening 248 of the isolation trench 216 to achieve electrical isolation. Therefore, even if the deposition of the insulating layer 218 inside the isolation trench 216 is discontinuous, no short circuit problem will occur in the light-emitting region 232 as no conductive material is filled in the isolation trench 216.

This embodiment can effectively solve the short circuit and disconnection problems, so that the reverse leakage current detection means is not required, and the production yield of the series LED structure 200 can be improved greatly, thereby reducing the manufacturing cost.

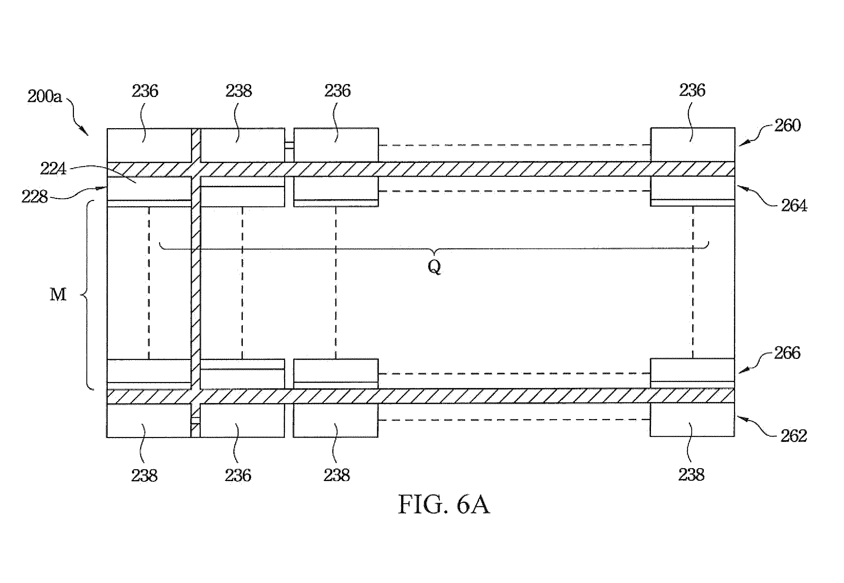

FIG. 6A is a top view of an LED structure according to another embodiment of the present invention. In this embodiment, the architecture of the LED structure 200a is substantially the same as that of the LED structure 200 in the above embodiment, and the difference of the two lies in that the LED structure 200a includes at least Q×M LED chips 228, and the LED structure 200a includes Q electrode pads on each of two opposite sides thereof.

In the LED structure 200a, the LED chips 228 are arranged in an array of Q columns and M rows. In this embodiment, the LED chips 228 of each column are connected to one another in series, and the columns are connected to one another in series. Therefore, the LED structure 200a is formed by the LED chips 228 connected in series.

Moreover, the two opposite sides of the LED structure 200a are respectively provided with electrode pad rows 260 and 262. Each of the electrode pad rows 260 and 262 includes Q electrode pads, and each of the electrode pad rows 260 and 262 is formed by arranging first conductivity type electrode pads 238 and second conductivity type electrode pads 236 in a staggered manner. In the electrode pad row 260, the electrode pads are arranged sequentially in such a staggered manner that one second conductivity type electrode pad 236 follows one first conductivity type electrode pad 238. On the other hand, in the electrode pad row 262, the electrode pads are arranged sequentially in such a staggered manner that one first conductivity type electrode pad 238 follows one second conductivity type electrode pad 236. Therefore, in the LED structure 200a, two electrode pads in the electrode pad rows 260 and 262 that are located on two opposite sides of each row of the LED chips 228 are of different conductivity types, for example, one of the electrode pads is of the first conductivity type, and the other electrode pad is of the second conductivity type.

The electrode pads in the electrode pad row 260 are respectively electrically connected to the LED chip 228 of a first row 264 of each column. On the other hand, the electrode pads in the electrode pad row 262 are respectively electrically connected to the LED chip 228 of a last row 266 of each column. In this embodiment, the LED chips 228, the electrode pad rows 260 and 262 are connected in series. That is to say, the 1st second conductivity type electrode pad 236 of the electrode pad row 260 is connected in series with the LED chips 228 of the first column, and is then connected in series with the 1st first conductivity type electrode pad 238 of the electrode pad row 262. Then, the 1st first conductivity type electrode pad 238 of the electrode pad row 262 is connected in series with a second conductivity type electrode pad 236 next thereto, the second conductivity type electrode pads 236 is then connected in series with the LED chips 228 of the second column, and the LED chips 228 of the second column are then connected in series with the 2nd electrode pad of the electrode pad row 260, that is, the first conductivity type electrode pad 238. The 2nd electrode pad (the first conductivity type electrode pad 238) of the electrode pad row 260 is then connected in series with the 3rd electrode pad (the second conductivity type electrode pad 236). According to such a sequence, the electrode pad row 260, the LED chips 228 and the electrode pad row 262 are connected in series together.

Through the disposition of the electrode pad rows 260 and 262 and the series circuit design, an inspector can directly check the forward/reverse current of each column one by one through the electrode pads of the two opposite sides of each column. In this way, a short circuit defect in the LED structure 200a can be determined successfully.

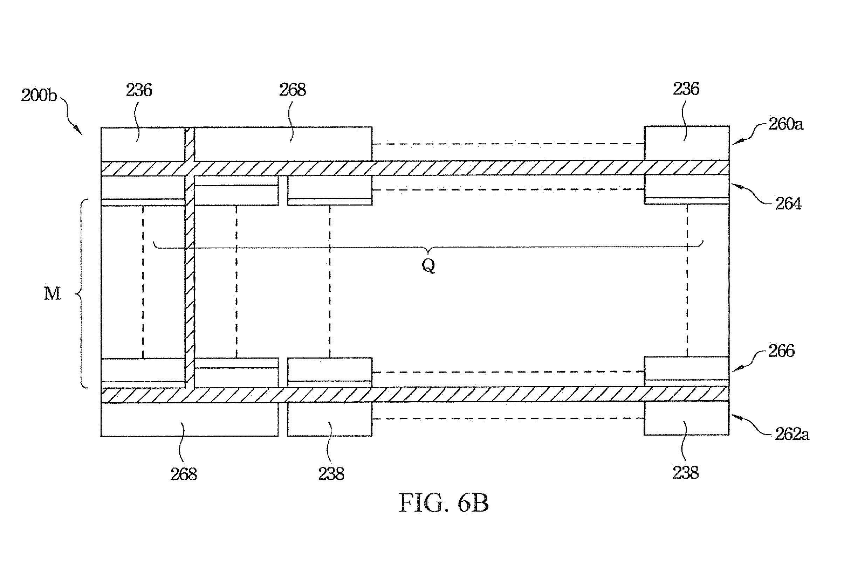

FIG. 6B is a top view of an LED structure according to still another embodiment of the present invention. In this embodiment, the architecture of the LED structure 200b is substantially the same as that of the LED structure 200a in the above embodiment, and the difference of the two lies in that in the LED structure 200b, the electrode pads in the LED structure 200a that are directly connected in series are integrated into one electrode pad.

In the electrode pad row 260a of the LED structure 200b, a large electrode pad 268 is used to replace the two electrode pads of the electrode pad row 260 in the LED structure 200a that are directly connected in series, for example, the 2nd and 3rd electrode pads. The electrode pad 268 is disposed adjacent to the LED chips 228 of the first rows 264 of the second column and the third column. On the other hand, in the electrode pad row 262a, a large electrode pad 268 is used to replace the two electrode pads of the electrode pad row 262 in the LED structure 200a that are directly connected in series, for example, the 1st and the 2nd electrode pads. The electrode pad 268 is disposed adjacent to the LED chips 228 of the last rows 266 of the first column and the second column.

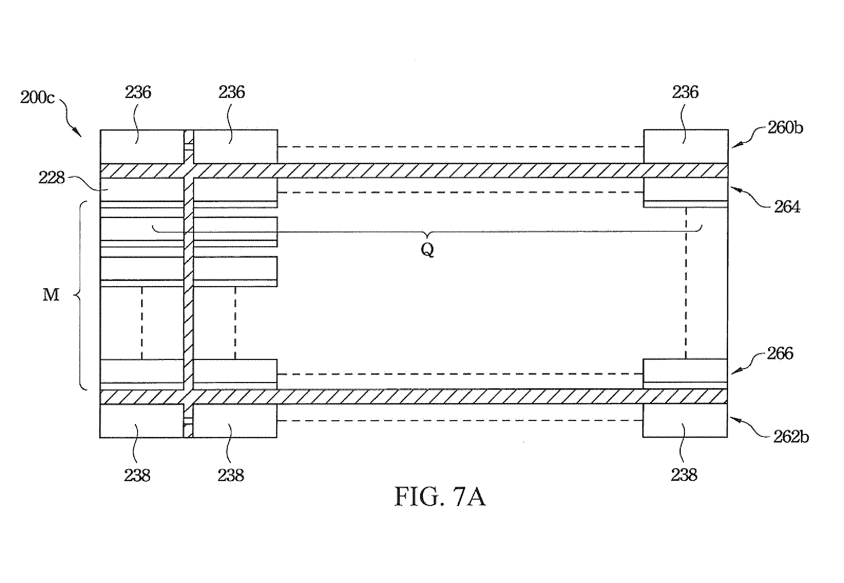

FIG. 7A is a top view of an LED structure according to yet another embodiment of the present invention. In this embodiment, the architecture of the LED structure 200c is substantially the same as that of the LED structure 200a in the above embodiment, and the difference of the two lies in that each of the electrode pad rows 260b and 262b of the LED structure 200c includes electrode pads of the same conductivity type.

In the LED structure 200c, the electrode pad row 260b is formed by a plurality of second conductivity type electrode pads 236. Among the second conductivity type electrode pads 236, any two neighboring second conductivity type electrode pads 236 are directly electrically connected to each other. Furthermore, the second conductivity type electrode pads 236 are respectively electrically connected to the LED chips 228 of the first row 264. In addition, the electrode pad row 262b is formed by a plurality of first conductivity type electrode pads 238. Among the first conductivity type electrode pads 238, any two neighboring first conductivity type electrode pads 238 are directly electrically connected to each other. The first conductivity type electrode pads 238 are respectively electrically connected to the LED chips 228 of the last row 266. Moreover, in the LED structure 200c, the LED chips 228 of each column are connected in series with one another, and the LED chips 228 of every column are connected in parallel through the electrode pad rows 260b and 262b.

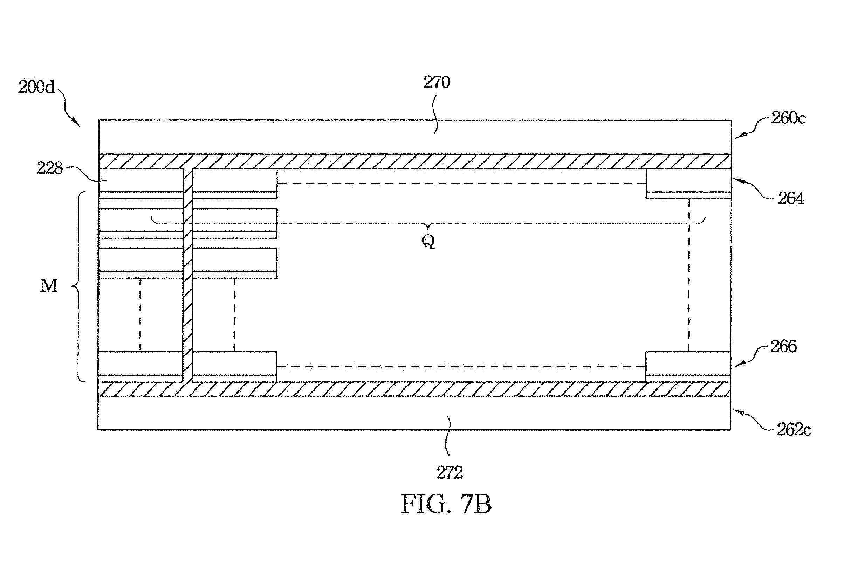

FIG. 7B is a top view of an LED structure according to yet another embodiment of the present invention. In this embodiment, the architecture of the LED structure 200d is substantially the same as that of the LED structure 200c in the above embodiment, and the difference of the two lies in that in the LED structure 200d, the two electrode pad rows of the LED structure 200c are integrated into two large electrode pads 270 and 272.

In the LED structure 200d, all the second conductivity type electrode pads 236 in the electrode pad row 260c that are equivalent to the electrode pad row 260b in the LED structure 200c are integrated into a single electrode pad 270. The electrode pad 270 is disposed adjacent to all the LED chips 228 of the first row 264. Furthermore, the electrode pad 270 is electrically connected to all the LED chips 228 of the first row 264. On the other hand, all the first conductivity type electrode pads 238 in the electrode pad row 262c that are equivalent to the electrode pad row 262b in the LED structure 200c are integrated into a single electrode pad 272. The electrode pad 272 is disposed adjacent to all the LED chips 228 of the last row 266. The electrode pad 272 is electrically connected to all the LED chips 228 of the last row 266. Likewise, in the LED structure 200d, the LED chips 228 of each column are connected in series with one another, and the LED chips 228 of every column are connected in parallel through the electrode pad rows 260c (the electrode pad 270) and 262c (the electrode pad 272).

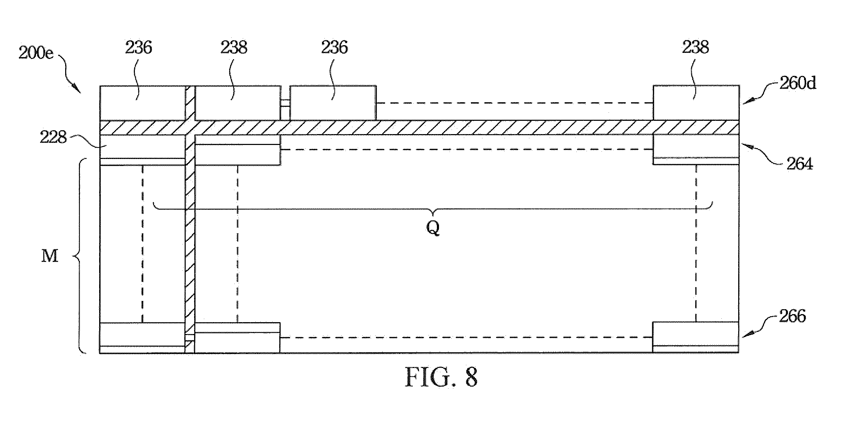

FIG. 8 is a top view of an LED structure according to yet another embodiment of the present invention. In this embodiment, the architecture of the LED structure 200e is substantially the same as that of the LED structure 200a in the above embodiment, and the difference of the two lies in that the LED structure 200e has only one electrode pad row 260d.

In the LED structure 200e, the electrode pad row 260d may be disposed adjacent to the LED chips 228 of the first row 264. In another embodiment, the electrode pad row 260d may be disposed adjacent to the LED chips 228 of the last row 266. The electrode pad row 260d includes Q electrode pads, and the electrode pad row 260d is formed by arranging a plurality of first conductivity type electrode pads 238 and a plurality of second conductivity type electrode pads 236 in a staggered manner. The first conductivity type electrode pads 238 and the second conductivity type electrode pads 236 are respectively electrically connected to the LED chips 228 of the first row 264. Moreover, the LED chips 228 of the first row 264 are connected in series with the corresponding electrode pads in the electrode pad row 260d.

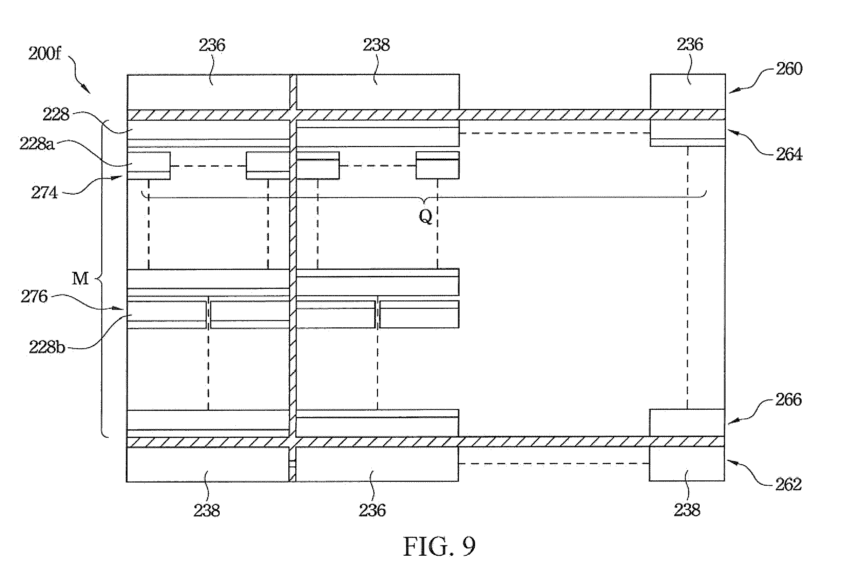

FIG. 9 is a top view of an LED structure according to yet another embodiment of the present invention. In this embodiment, the architecture of the LED structure 200f is substantially the same as that of the LED structure 200a in the above embodiment, and the difference of the two lies in that the LED structure 200f has LED chips 228, 228a and 228b of various different sizes.

Each column of the LED structure 200f includes LED chips 228, 228a and 228b of various different sizes. Moreover, the LED chips 228a of the row 274 may be connected in parallel first, and then connected in series with the LED chips 228 and 228b of other rows. The LED chips 228b of the row 276 may be connected in parallel first, and then connected in series with the LED chips 228 and 228a of other rows. In another embodiment, the LED chips 228a of the row 274 may be connected in series first, and then connected in series with the LED chips 228 and 228b of other rows. The LED chips 228b of the row 276 may be connected in series first, and then connected in series with the LED chips 228 and 228a of other rows. Moreover, the LED chips 228 are connected in series with the electrode pad rows 260 and 262.

The embodiments are chosen and described in order to explain the principles of the invention and their practical application so as to activate others skilled in the art to utilize the invention and various embodiments and with various modifications as are suited to the particular use contemplated. Accordingly, the scope of the present invention is defined by the appended claims rather than the foregoing description and the exemplary embodiments described therein.

## Claims

1. A light-emitting diode (LED) structure, comprising:
an insulating substrate;
a plurality of LED chips, wherein each of the LED chips comprises a first conductivity type semiconductor layer, an active layer and a second conductivity type semiconductor layer stacked in sequence on a surface of the insulating substrate, and each of the LED chips includes a mesa structure, an exposed portion of the first conductivity type semiconductor layer adjacent to the mesa structure, and a first isolation trench disposed in the mesa structure; and
a plurality of interconnection layers, respectively connecting neighboring two of the LED chips.

2. The LED structure according to claim 1, wherein in each of the LED chips, a bottom of the first isolation trench exposes the surface ofthe insulating substrate.

3. The LED structure according to claim 1, wherein each of the LED chips further comprises an insulating layer, and the insulating layer is filled in the first isolation trench to close an opening of the first isolation trench.

4. The LED structure according to claim 3, wherein each ofthe LED chips further comprises a current blocking layer between the interconnection layer on the mesa structure and the insulating layer.

5. The LED structure according to claim 4, wherein each of the LED chips further comprises a transparent conductive layer between the interconnection layer on the mesa structure and the current blocking layer, and extending on the second conductivity type semiconductor layer of the mesa structure.

6. The LED structure according to claims 4, wherein each of the LED chips further comprises a transparent conductive layer disposed adjacent to the current blocking layer, and the interconnection layer extends on and covers a part of the transparent conductive layer.

7. The LED structure according to claim 1, wherein each of the interconnection layers extends from the exposed portion of the first conductivity type semiconductor layer of one of the neighboring two LED chips to the mesa structure of the other one of the neighboring two LED chips.

8. The LED structure according to claim 7, wherein each of the LED chips further comprises a current blocking layer, and the current blocking layer covers a side surface of the mesa structure where the interconnection layer is located.

9. The LED structure according to claim 1, wherein the LED chips are arranged in an array, and the array comprises a plurality of rows and a plurality of columns, wherein the LED chips are connected to one another in series or in parallel; and
at least one electrode pad row, disposed adjacent to a first row of the array, and respectively electrically connected to the LED chips of the first row.

10. A method for manufacturing a light-emitting diode (LED) structure, comprising:
providing an insulating substrate;
forming an epitaxial structure, wherein the epitaxial structure comprises a first conductivity type semiconductor layer, an active layer and a second conductivity type semiconductor layer stacked in sequence on a surface of the insulating substrate;
forming a plurality of first isolation trenches and a plurality of second isolation trenches in the epitaxial structure to define a plurality of LED chips, wherein the first isolation trenches are respectively adjacent to the second isolation trenches;
removing a part of the second conductivity type semiconductor layer and a part of the active layer to define a mesa structure and an exposed portion of the first conductivity type semiconductor layer of each of the LED chips, wherein each ofthe LED chips comprises one of the first isolation trenches, and the one of the first isolation trenches is disposed in the mesa structure; and
forming a plurality of interconnection layers to respectively connect neighboring two of the LED chips.

11. The method for manufacturing an LED structure according to claim 10, wherein before the step of removing the part of the second conductivity type semiconductor layer and the part of the active layer, the method further comprises forming a plurality of first insulating layers and a plurality of second insulating layers, and respectively filling the first insulating layers and the second insulating layers in the first isolation trenches and the second isolation trenches.

12. The method for manufacturing an LED structure according to claim 11, wherein the step of forming the first insulating layers and the second insulating layers further comprises:
forming an insulating material covering the epitaxial structure, and filling the insulating material in the first isolation trenches and the second isolation trenches; and
performing an etch back step to remove a part of the insulating material.

13. The method for manufacturing an LED structure according to claim 11, wherein after the step of forming the first insulating layers and the second insulating layers, the method further comprises:
forming a plurality of first current blocking layers respectively located on the mesa structures, wherein each of the first current blocking layers is located between the interconnection layer on the mesa structure and the first insulating layer;
forming a plurality of second current blocking layers respectively located on the second insulating layers; and
forming a plurality of transparent conductive layers respectively located on the mesa structures, wherein each of the transparent conductive layers is located between the interconnection layer on the mesa structure and the first current blocking layer, and extends on the second conductivity type semiconductor layer of the mesa structure.

14. The method for manufacturing an LED structure according to claim 10, wherein each of the interconnection layers is directly connected from the exposed portion of the first conductivity type semiconductor layer of one of the neighboring two LED chips to a side surface of the mesa structure of the other one of the neighboring two LED chips, and extends on the mesa structure.

15. The method for manufacturing an LED structure according to claim 10, wherein the LED chips are arranged in an array, and the array comprises a plurality of rows and a plurality of columns, wherein the LED chips are connected to one another in series or in parallel; and
at least one electrode pad row is formed, which is disposed adjacent to a first row of the array, and respectively electrically connected to the LED chips of the first row.
